# EUROPEAN PATENT SPECIFICATION

(11) **EP 0 430 605 B1**
(45) Date of publication and mention of the grant of the patent: **15.02.1995**
(21) Application number: 90312797.5
(22) Date of filing: 23.11.1990
(51) Int. Cl.: H04B 7/26, H04Q 7/20, H03D 1/22

(54) **Frequency detector based on a digital phase lock loop**
Frequenzdetektor auf einer digitalen Phasenregelschleife basierend
Détecteur de fréquence basé sur une boucle de verrouillage de phase numérique

(30) Priority: 01.12.1989 FI 895767
(43) Date of publication of application: 05.06.1991
(73) Proprietor: NOKIA MOBILE PHONES LTD., 24101 Salo (FI)
(72) Inventor: Strömmer, Esko Kaarlo Juhani, SF-90540 Oulu (FI); Tenhunen, Juha Heikki, SF-90540 Oulu (FI); Kivari, Raimo Kalervo, SF-90830 Haukipudas (FI)
(74) Representative: Adams, William Gordon

(56) References cited:
- EP-A- 0 010 344
- US-A- 4 025 853
- 37TH IEEE VEHICULAR TECHNOLOGY CONFERENCE 1 June 1987, TAMPA (US) pages 424 -429; T. OKAMOTO ET AL: 'baseband unit for portable cellular radio telephone'
- PATENT ABSTRACTS OF JAPAN vol. 11, no. 59 (E-482)24 February 1987

## Description

The invention relates to a frequency detector for use in a radio telephone, the detector comprising a circuit for synchronizing a rectangular-waveform input signal formed from a signal being examined to a clock frequency, a digital phase lock loop (DPLL) which produces from the synchronized input signal being examined a regenerated digital output signal the phase difference of which in relation to the input signal is dependent on the difference between the frequency of the linearly synchronized input signal and a selectable average frequency of the phase lock loop, and a digital detector part which detects whether the signal being examined, arriving at the frequency detector, is within a predetermined frequency range. The invention has been applied in the SAT detector of the modem circuit for TACS and AMPS mobile telephones.

In the AMPS and TACS radio telephone system a base station transmits during a call an analog sinusoidal control signal, so-called SAT signal (supervisory audio tone), the purpose of which is to supervise the quality of the connection between a mobile telephone and base stations. A mobile station must be capable of receiving the SAT signal, of interpreting it correctly as a predetermined nominal frequency, and of retransmitting the regenerated SAT signal to the base station. The nominal frequences of the SAT signal are 5970, 6000 or 6030 Hz. At the time of a call setup and in a handover situation, a mobile telephone receives information on the available SAT frequency from a digital control message transmitted by the base station, in which the assumed frequency is given. If the mobile telephone does not receive any SAT signal within a predetermined period, or if the received frequency differs from that given in the control message, the telephone call is disconnected.

For detecting the SAT signal in a modem circuit of a subscriber apparatus it is known to use circuitry based on an analog phase lock loop and on the counting of the pulses of its output signal. In it the incoming SAT signal is applied via a STIF bandpass filter to an analog comparator, in which a rectangular wave is formed from the signal. Thereafter the signal is applied to an analog phase lock loop and to an SAT frequency detector. The detector functions by comparing the frequency of the received rectangular wave with the crystal frequency of the modem circuit. The comparing takes place with the aid of a counter chain, and the modem circuit reports the result once in 85 ms. The disadvantage of a system such as this is that it has too low a tolerance for input-signal noise and has phase noise in the output signal, which is manifest in a widening of the spectrum on both sides of the SAT frequency, the rather large number of components required, the surface area requirement of the circuit card, and the need for tuning during production.

It is also known to use, for SAT signal detection, systems based on a digital phase lock loop, aiming at eliminating the problems caused by an analog phase lock loop. There is used, for example, a modem circuit which is made up of three microcircuits, one of which contains the SAT components. The size of this circuit is approx. 3000 gate equivalents, and it is packed on an 80-pin IC-package. In it the detector part examines only the locking of the phase lock loop, and it is rather large. Another modem circuit has two microcircuits, which require as many as seventeen external components in order to function. In spite of the digital phase lock loop its detector part is based on detecting, by means of analog integration, the locking of the phase lock loop. Also other known systems require external components.

The object of the present invention is to provide a detector, in particular a SAT-detector, which is based on a digital phase lock loop, does not require external components, is easy to integrate into one microcircuit, and need not be tuned and tested in connection with production, and the functioning of which with a noisy input signal is better.

The invention is characterized in that the detector part of the frequency detector comprises a detection timer which forms a detection sequence of the desired length, at the end of which the output signal of the detector part is updated; a first phase detector, which has a detection window at which it counts those rising or falling edges of the synchronized input signal (SSAT) coinciding with the window; a second phase detector, which also has a detection window of its own, at which it counts those rising or falling edges of the synchronized input signal coinciding with the window, the detection windows being made up of the SAT signal (S01) formed by the digital phase lock loop and its harmonics (S02, S04, S08), in which case, if at the end of a detection sequence the counter of the first phase detector exceeds and the counter of the second phase detector falls short of its predetermined threshold values, the detector part will interpret the signal to be examined as correct.

At the beginning of a call or in a handover situation (transfer from one base station to another), a base station transmits a digital control message which includes an SCC code (SAT color code), which detects as follows the SAT frequency used during the call:

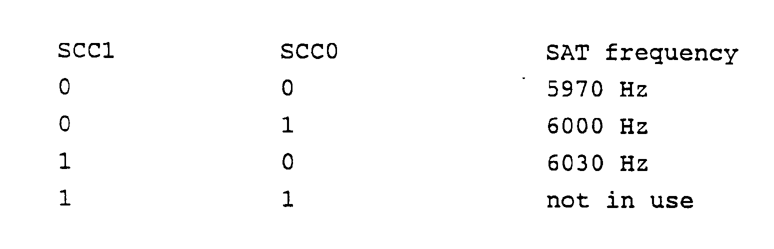

These codes SCC1 and SCC0 are applied to the digital first-order phase lock loop, in which case its average frequency will be the frequency indicated by their combination, according to the above table. At the detector of the modem circuit of the telephone there will arrive an analog input signal, which may, in addition to an SAT signal of any of the above frequencies, contain voice or data. The input signal is filtered in a band-pass filter, is thresholded in a comparator, and is synchronized, for example in flip-flop circuits, with the detector clock signal, and is thereafter applied to the digital phase lock loop. The phase lock loop itself may be a standard circuit, and its structure does not constitute a part of the present invention. The phase lock loop will produce in digital form a regenerated SAT signal and its 2nd, 4th and 8th harmonics, from which an analog regenerated SAT signal to be transmitted to the base station can be formed. The SAT signal obtained from the phase lock loop is applied to the detector part according to the invention, which at the end of its detection sequence will in its output signal provide information on whether an SAT signal of the correct frequency has been received.

The invention is described below in greater detail, with reference to the accompanying figures, in which
- Figure 1: depicts a block diagram of the frequency detector,
- Figure 2: depicts a block diagram of the detector part of the frequency detector,
- Figure 3: detects the typical locations and widths of the detection windows of the phase detectors, and
- Figure 4: depicts the operation of the frequency detector, with a noisy input signal.

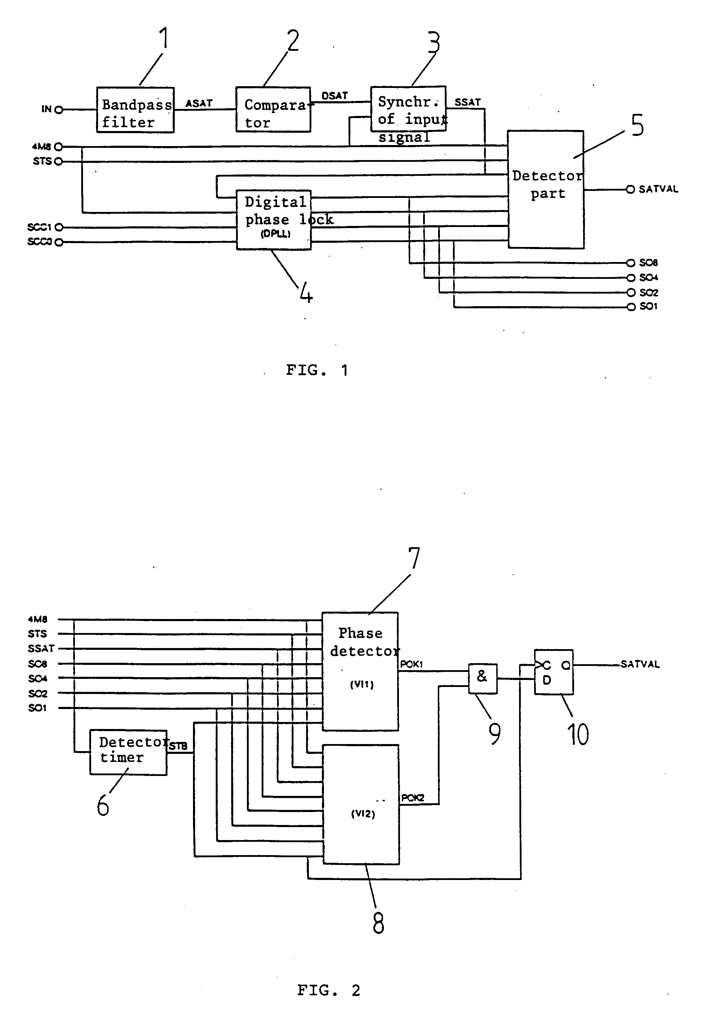

In the frequency detector block diagram according to Figure 1, the IN signal is the analog input signal of the detector, arriving at the modem circuit, a signal which in addition to an SAT signal may contain voice and data. The input signal is filtered in a bandpass filter 1, is thresholded in a comparator 2 (is converted to a rectangular wave), and is synchronized in circuit 3, which may be a flip-flop circuit, with the clock signal of the phase lock loop 4. The DC level of the output of the bandpass filter 1 has to be the same as the DC level of the comparator 2, since the thresholded signal has to be symmetrical. In addition to the clock signal and the IN signal there arrives at the detector a signal STS from the command word of the modem circuit, the STS signal serving as the detector sensitivity selector (the signal is used for selecting one of the two possible noise levels at which the detector will function), and signals SCC1 and SCC0, which will determine the average frequency of the phase lock loop, as described above. The phase lock loop 4 is a first-order digital phase lock loop, its essential characteristic from the viewpoint of the detector part being that the phase difference between the incoming and outgoing signals is linearly dependent on the difference between the input signal frequency and the average frequency of the phase lock loop.

From the phase lock loop 4 there is obtained in digital form a regenerated SAT signal (S01) and its 2nd, 4th and 8th harmonics (S02, S04, S08), from which an analog SAT signal to be transmitted to the base station can be formed. When necessary, it is possible to obtain from the phase lock loop also other harmonic components in addition to the above.

The detector part 5, a block diagram of which is shown in Figure 2, is essential for the operation. The input signals of the detector part are the digital phase lock loop output signals S01, S02, S04, S08 and the received SAT signal SSAT, synchronized with the clock signal, as well as the sensitivity selector signal STS and the clock signal 4.8 MHz. The detector part includes a detection timer 6, which forms a detection sequence of the desired length, at the end of which the detector part 5 output signal SATVAL, which detects the reception of an SAT signal of the correct frequency, is updated. The detector part 5 includes two phase detectors VI1 and VI2, based on counters and referred to using reference numerals 7 and 8. Each of the detectors VI1 and VI2 has its own detection window made up of the signal S01 and its harmonics, obtained from the phase lock loop. The detectors VI1 and VI2 count those either rising or falling edges of the input signal SSAT which coincide with the detector window. In the present example they count the falling edges. The windows are located in such a manner that, when the phase lock loop 4 is locked within a certain frequency range, which is within the lock-in band of the phase lock loop, VI1 is counting continuously and VI2 is not counting.

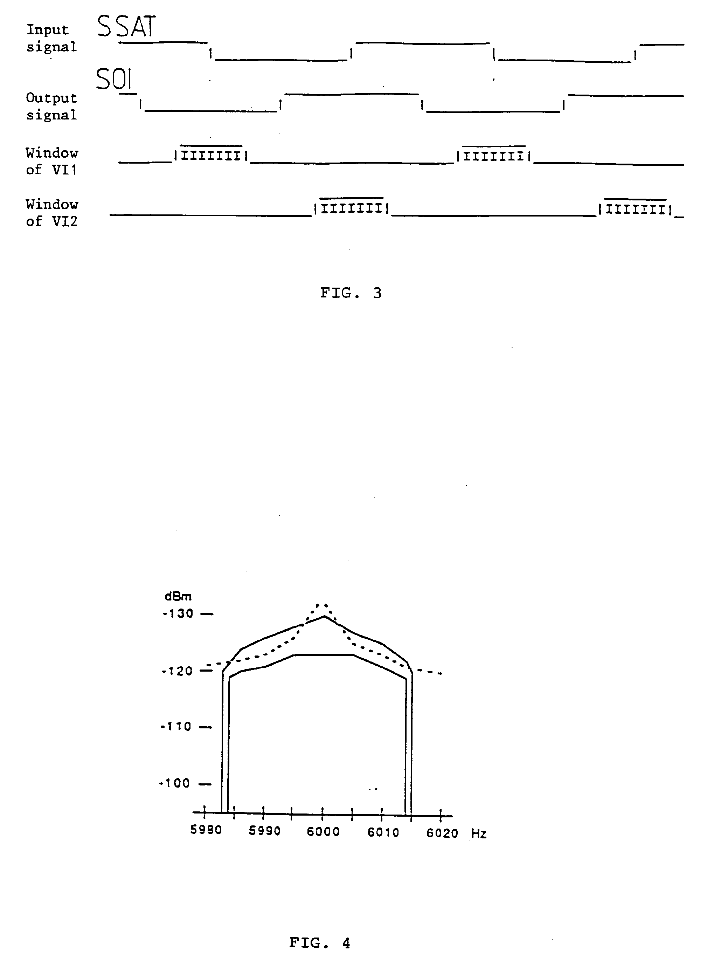

The typical width and location of the phase windows in relation with the incoming and outgoing signals when the phase lock loop 4 is in the locked state is illustrated in Figure 3. It can be seen that the window of the phase detector VI1 is at the falling edge of the input signal SSAT and the window of VI2 is at the rising edge. Only VI1 is counting, since only the falling edges are counted. Furthermore, in this example VI1 counts only one falling edge per window even if there happen to be more of them, for example because of noise. The detection timer 6 determines the length of the detection sequence, and the counters are always zeroed at the beginning of a detection sequence. Whether an incoming signal SSAT is within the desired frequency range can now be determined from the final value of the counters at the end of the detection sequence, since VI1 ought to have counted all the falling edges of the input signals and VI2 ought not to have counted a single input signal edge. Since, because of noise, the locations of the edges of an input signal SSAT usually cannot be predicted with precision, a threshold value somewhat lower than the noise is selected for the counter of VI1 and somewhat higher than the noise for the counter of VI2. If at the end of a detection sequence the counter VI1 exceeds and the counter of VI2 falls short of its threshold value, the detector part will give a positive result (i.e. that the received signal is really an SAT signal). Both of the said conditions must be in force simultaneously. A condition is checked at the AND gate 9.

The frequency detector characteristics such as its frequency range and its sensitivity to noise can be affected by selecting suitable values for certain parameters. Such parameters include (the value in parentheses concerns specifically the SAT application):
- length of the detection sequence (80 ms)
- average frequency of the phase lock loop (depends on the state of the SCC0 and SCC1 signals, as presented above)
- bandwidth of the phase lock (+/-31 Hz)
- width of the detection window of VI1 (90°) and the location of its center point (90° after the falling edge of the output signal)
- width of the detection window of VI2 (360°, i.e. the counter counts all edges) and the location of its center point
- threshold value of the counter of VI1 (192 or 224, depending on the state of the STS signal) and threshold value of the counter of VI2 (640)
- the basic clock frequency of the detector (4.8 MHz).

The length of the detection sequence has to be selected as a compromise between the speed of the detector and its noise properties. It is advantageous to select as the average frequency of the phase lock loop the average frequency of the frequency band to be detected. In this case 90° from the falling edge of the output signal S01 is to be selected as the location of the center point of the detection window of VI1 and 270° from the falling edge of the output signal is to be selected as the location of the center point of the detection window of VI2, as shown in Figure 3. The bandwidth of the phase lock loop has to be greater than or equal to the width of the detection band. Widening of the phase lock loop band speeds up its step response but increases the noise in the output signal. On the other hand, if the bandwidth of the phase lock loop is very close to the width of the detection band, the noise characteristics on the edges of the detection band are clearly poorer than in the middle of the detection band. The detection bandwidth multiplied by two has been found to be a suitable phase lock loop bandwidth in the SAT application. When a suitable phase lock loop bandwidth has been selected, the width of the detection window of VI1 is selected on the basis of the following formula:$\text{VI1 detection window width =} \frac{\text{detection bandwidth}}{\text{phase lock loop bandwidth}} \text{x 180°}$

After this there is no absolute requirement for the width of the detection window of VI2, and it may be set, for example, at the same value as the width of the window of VI1. When the other parameters have been selected, the threshold values of the counters can be determined experimentally at such levels that the desired noise characteristics are accomplished. The higher the threshold value of the counter of VI1 and the lower the threshold value of the counter of VI2, the lower the noise tolerance of the detector.

According to the parameter list presented above and the Formula, the width of the detector band in the SAT application is +/-15 Hz.

The operation of the detector according to the invention was investigated using various radio signal levels and various SAT frequencies, and the curves depicted in Figure 4 were obtained. The average frequency selected for the phase lock loop was 6000 Hz and the threshold value of VI1 was 192. The dashed line depicts a curve below which the phase lock loop was in the locked state. Below the lower uninterrupted line the SATVAL signal was high and above the upper uninterrupted line the SATVAL signal was low. Between these lines the SATVAL signal varied its state. According to this figure, the detector still functioned when the rf signal level was-123 dBm. In an application integrated on a silicon chip the sensitivity was -123 dBm.

Owing to its entirely digital implementation, the detector according to the invention can be in its entirety easily integrated into one microcircuit, and it need not be tuned and tested in connection with production. The elimination of the external components of the modem circuit reduces costs and saves labor in production. The system somewhat reduces the silicon chip surface area requirement, since the harmonic components of the SAT frequency, obtained from the phase lock loop, enable the analog components of the outgoing SAT signal to be implemented in a simpler manner. In the system the noise level of the outgoing signal is low and the detection of the SAT signal is good also at the edges of the audibility area of a base station.

Even though, above, the invention has been described specifically in the detection of an SAT signal in the modem circuit of a radio telephone, it is self-evident that it can also be used in other contexts in which frequency detection is required. Such potential uses include various applications in measuring and communications, in which information is required regarding whether an input signal is within the desired frequency range or not. If information regarding the frequency is not obtained from a control message in the input signal, as is the case in the SAT application, the frequency detector can be modified so that it will seek the input signal frequency by experimenting with various basic clock frequencies, with average frequencies of the phase lock loop, and with detector sensitivities (threshold values of the VI1 and VI2 counters and the width of the detection windows).

## Claims

1. A frequency detector, in particular a supervisory audio tone (SAT)-frequency detector in a radio telephone system, the detector comprising a circuit (3) for synchronising a rectangular-waveform input signal (DSAT) formed from a signal (IN) to be examined with a clock frequency, a digital phase lock loop (4), which produces a digital output signal (S01) regenerated from the synchronized input signal (SSAT) outputted from the circuit (3), the phase difference of the digital output signal (S01) in relation to the synchronized input signal (SSAT) being dependent on the difference between the frequency of the linearly synchronized input signal (SSAT) and a selectable average frequency of the digital phase lock loop (4), and a digital detector part (5), which detects whether the synchronized input signal (SSAT) arriving at the detector part (5) is within a predetermined frequency range, **characterized** in that the detector part (5) of the frequency detector comprises a detection timer (6) forming a detection sequence of a desired length, at the end of which the output signal (SATVAL) of the detector part (5) is updated, a first phase detector VI1 (7) having a detection window in which it counts those rising or falling edges of the synchronized input signal (SSAT) coinciding with the window, and a second phase detector VI2 (8) which also has a detection window of its own, in which it counts those rising or falling edges of the synchronized input signal (SSAT) coinciding with the window, the detection windows being formed from the output signal (S01) and from its harmonics (S02, S04, S08) formed by the digital phase lock loop (4), in which case, if at the end of a detection sequence the counter of the first phase detector VI1 (7) exceeds and the counter of the second phase detector VI2 (8) falls short of its predetermined threshold value, the detector part (5) will interpret the signal (IN) to be examined as correct.

2. A frequency detector according to Claim 1, **characterized** in that the input signals of the detector part (5) are the input signal (SSAT) synchronized with the clock frequency of the frequency detector and thresholded, the clock signal, a detection sensitivity selection signal (STS), the output signal (S01) and its harmonics (S02, S04, S08) of the digital phase lock loop, and the output signal (SATVAL) of the detector part (5) is the output of an AND gate (9) at the end of the detection sequence, the input signals of the gate being the outputs of the first VI1 (7) and second VI2 (8) phase detectors at the end of the detection sequence.

3. A frequency detector according to Claim 2, **characterized** in that the average frequency of the phase lock loop (4) is the same as the average frequency of the frequency band of the signal (IN) to be examined, and the location of the center point of the detection window of the first phase detector VI1 (7) is 90° after the falling edge of the output signal (S01) of the phase lock loop (4), and the location of the center point of the detection window of the second phase detector VI2 (8) is 270° after the falling edge of the output signal (S01) of the phase lock loop (4).

4. A frequency detector according to Claim 2, **characterized** in that the width (L) of the detection window of the first phase detector VI1 (7) is obtained from the formula$\text{window width =} \frac{\text{detection bandwidth}}{\text{phase lock loop bandwidth}} \text{x 180°}$ and the width of the detection window of the second phase detector VI2 (8) is freely selectable.

5. A frequency detector according to Claim 1, **characterized** in that its detection sensitivity and noise tolerance can be regulated by adjusting the threshold values of the counters of the first phase detector VI1 (7) and of the second phase detector VI2 (8) and the widths of the detection windows.

6. A frequency detector according to any of the above claims, **characterized** in that it can be used for detecting signals of different frequencies by changing the frequency of the basic clock or the average frequency of the phase lock loop (4), without at the same time having to change the other parameters of the detector part (5).

## Patentansprüche

1. Frequenzdetektor, insbesondere Audio-Tonsignal (SAT)-Überwachungs-Frequenzdetektor in einem Hochfrequenz-Telefonsystem, wobei der Detektor folgendes enthält:
eine Schaltung (3) zur Synchronisierung eines rechteckförmigen Eingangssignals (DSAT), das aus einem mit einer Taktfrequenz zu prüfenden Signal (IN) gebildet ist,
eine digitale Phasenregelschleife (4), die ein aus dem synchronisierten Eingangssignal (SSAT) regeneriertes und vom Ausgang der Schaltung (3) abgeleitetes digitales Ausgangssignal (SO1) erzeugt, wobei die Phasendifferenz des digitalen Ausgangssignals (SO1) relativ zu dem synchronisierten Eingangssignal (SSAT) von der Differenz zwischen der Frequenz des linear synchronisierten Eingangssignals (SSAT) und einer wählbaren mittleren Frequenz der digitalen Phasenregelschleife (4) abhängig ist,
und einen digitalen Detektorteil (5), welcher detektiert, ob das an dem Detektorteil (5) ankommende synchronisierte Eingangssignal (SSAT) innerhalb eines vorbestimmten Frequenzbereiches liegt, **dadurch gekennzeichnet**, daß der Detektorteil (5) des Frequenzdetektors folgendes enthält:
einen Detektions-Timer (6), der eine Detektionsfolge einer gewünschten Länge bildet, an derem Ende das Ausgangssignal (SATVAL) des Detektorteils (5) auf den neusten Stand gebracht wird,
einen ersten Phasendetektor VI1 (7) mit einem Detektionsfenster, in dem er die jenigen ansteigenden oder abfallenden Kanten des synchronisierten Eingangssignals (SSAT) zählt, die mit dem Fenster zusammenfallen,
und einen zweiten Phasendetektor VI2 (8), der auch ein eigenes Detektionsfenster aufweist, in dem er diejenigen ansteigenden oder abfallenden Flanken des synchronisierten Eingangssignals (SSAT) zählt, die mit dem Fenster zusammenfallen, wobei die Detektionsfenster aus dem Ausgangssignal (SO1) und seinen Harmonischen (SO2, SO4, SO8) gebildet sind, die durch die digitale Phasenregelschleife (4) erzeugt werden, wodurch dann, wenn am Ende einer Detektionsfolge der Zähler des ersten Phasendetektors VI1 (7) den vorbestimmten Schwellwert übersteigt und der Zähler des zweiten Phasendetektors VI2 (8) kurz unter seinen vorbestimmten Schwellwert fällt, der Detektorteil (5) das zu prüfende Signal (IN) als korrekt interpretiert.

2. Frequenzdetektor nach Anspruch 1, **dadurch gekennzeichnet**, daß die Eingangssignale des Detektorteils (5) durch das mit der Taktfrequenz des Frequenzdetektors synchronisierte und über den Schwellwert geführte Eingangssignal (SSAT), das Taktsignal, ein Selektionssignal (STS) für die Detektionsempfindlichkeit, das Ausgangssignal (SO1) und seine Harmonischen (SO2, SO4, SO8) der digitalen Phasenregelschleife gebildet sind und daß das Ausgangssignal (SATVAL) des Detektorteils (5) durch das Ausgangssignal eines UND-Tores (9) am Ende der Detektorfolge gebildet ist, wobei die Eingangssignale des Tores durch die Ausgangssignale des ersten Phasendetektors VI1 (7) und des zweiten Phasendetektors VI2 (8) am Ende der Detektionsfolge gebildet sind.

3. Frequenzdetektor nach Anspruch 2, **dadurch gekennzeichnet**, daß die mittlere Frequenz der Phasenregelschleife (4) die gleiche ist wie die mittlere Frequenz des Frequenzbandes des zu prüfenden Signals (IN) und der Mittelpunkt des Detektionsfensters des ersten Phasendetektors VI1 (7) 90° nach der abfallenden Flanke des Ausgangssignals (SO1) der Phasenregelschleife (4) liegt und daß der Mittelpunkt des Detektionsfensters des zweiten Phasendetektors VI2 (8) 270° nach der abfallenden Flanke des Ausgangssignals (SO1) der Phasenregelschleife (4) liegt.

4. Frequenzdetektor nach Anspruch 2, **dadurch gekennzeichnet**, daß die Breite des Detektionsfensters des ersten Phasendetektors VI1 (7) sich aus der Gleichung$\text{Fensterbreite =} \frac{\text{Detektions-Bandbreite}}{\text{Bandbreite der Phasenregelschleife}} \text{x 180°}$ ergibt und die Breite des Detektionsfensters des zweiten Phasendetektors VI2 (8) frei wählbar ist.

5. Frequenzdetektor nach Anspruch 1, **dadurch gekennzeichnet**, daß seine Detektions-Empfindlichkeit und Störsignal-Toleranz durch Einstellung der Schwellwerte der Zähler des ersten Phasendetektors VI1 (7) und des zweiten Phasendetektors VI2 (8) sowie durch die Breiten der Detektionsfenster veränderbar sind.

6. Frequenzdetektor und einem der vorangehenden Ansprüche, **da****durch gekennzeichnet**, daß er durch Änderung der Frequenz des Grundtaktes oder der mittleren Frequenz der Phasenregelschleife (4) für die Detektion von Signalen verschiedener Frequenzen anwendbar ist, ohne daß gleichzeitig die anderen Parameter des Detektorteils (5) geändert werden müssen

## Revendications

1. Détecteur de fréquence, en particulier un détecteur de fréquence (SAT) de tonalité audio de supervision dans un système de radio-téléphone, le détecteur comprenant un circuit (3) pour synchroniser un signal d'entrée de forme d'onde rectangulaire (DSAT) formé à partir d'un signal (IN) qui doit être examiné avec une fréquence d'horloge, une boucle verrouillée en phase numérique (4) qui produit un signal de sortie numérique (S01) reconstitué à partir du signal d'entrée synchronisé sorti à partir du circuit (3) (SSAT), la différence de phase du signal de sortie numérique (S01) par rapport au signal d'entrée synchronisé (SSAT) étant fonction de la différence entre la fréquence de signal d'entrée synchronisé de manière linéaire (SSAT) et une fréquence moyenne sélectionnable de la boucle verrouillée en phase numérique (4) et une partie de détection numérique (5), qui détecte si le signal d'entrée synchronisé (SSAT) arrivant à la partie de détection (5) est à l'intérieur d'une plage de fréquence prédéterminée, caractérisé en ce que la partie de détection (5) du détecteur de fréquence comprend un temporisateur de détection (6) formant une séquence de détection d'une durée désirée à la fin de laquelle le signal de sortie (SATVAL) de la partie de détection (5) est mis à jour, un premier détecteur de phase VI1 (7) ayant une fenêtre de détection dans laquelle il compte les fronts montants ou descendants du signal d'entrée synchronisé (SSAT) coïncidant avec la fenêtre et un second détecteur de phase VI2 (8) qui comporte également une fenêtre de section particulière, dans laquelle il compte les fronts montants ou descendants du signal d'entrée synchronisé (SSAT) coïncidant avec la fenêtre, les fenêtres de détection étant formées à partir du signal de sortie (S01) et de ses harmoniques (S02, S04, S08) formés par la boucle verrouillée en phase numérique (4) et dans lequel cas, si à la fin d'une séquence de détection le compteur du premier détecteur de phase VI1 (7) dépasse sa valeur de seuil prédéterminé et que le compteur du second détecteur de phase VI2 (8) n'a pas atteint sa valeur de seuil prédéterminé, la partie de détection (5) interprètera le signal (IN) qui doit être examiné comme correct.

2. Détecteur de fréquence selon la revendication 1, caractérisé en ce que les signaux d'entrée de la partie de détection (5) sont le signal d'entrée (SSAT) synchronisé avec la fréquence d'horloge du détecteur de fréquence et comparé à un seuil, le signal d'horloge, un signal de sélection de sensibilité de détection (STS), le signal de sortie (S01) et ses harmoniques (S02, S04, S08) de la boucle verrouillée en phase numérique et le signal de sortie (SATVAL) de la partie de détection (5) est la sortie d'une porte ET (9) à la fin de la séquence de détection, les signaux d'entrée de la porte étant les sorties du premier détecteur de phase VI1 (7) et du second détecteur de phase VI2 (8) à la fin de la séquence de détection.

3. Détecteur de fréquence selon la revendication 2, caractérisé en ce que la fréquence moyenne de la boucle verrouillée en phase (4) est la même que la fréquence moyenne de la bande de fréquence du signal (IN) qui doit être examiné et l'emplacement du point central de la fenêtre de détection du premier détecteur de phase VI1 (7) est à 90° après le front descendant du signal de sortie (S01) de la boucle verrouillée en phase (4) et l'emplacement du point central de la fenêtre de détection du second détecteur de phase VI2 (8) est à 270° après le front descendant du signal de sortie (S01) de la boucle verrouillée en phase (4).

4. Détecteur de fréquence selon la revendication 2, caractérisé en ce que la largeur (L) de la fenêtre de détection du premier détecteur de phase VI1 (7) est obtenue à partir de la formule$\text{Largeur de la fenêtre =} \frac{\text{largeur de bande de détection}}{\text{largeur de bande de la boucle verrouillée en phase}} \text{x 180 °}$ et la largeur de la fenêtre de détection du second détecteur de phase VI2 (8) est sélectionnable de manière libre.

5. Détecteur de fréquence selon la revendication 1, caractérisé en ce que sa sensibilité de détection et sa tolérance au bruit peut être réglées en ajustant les valeurs de seuil des compteurs du premier détecteur de phase VI1 (7) et du second détecteur de phase VI2 (8) et les largeurs des fenêtres de détection.

6. Détecteur de fréquence selon l'une quelconque des revendications précédentes, caractérisé en ce qu'il peut être utilisé pour détecter des signaux de fréquences différentes en modifiant la fréquence de l'horloge de base ou la fréquence moyenne de la boucle verrouillée en phase (4) sans à avoir à changer les autres paramètres de la partie de détection (5) en même temps.
